# FASCICULE DE BREVET EUROPEEN

(11) **EP 4 492 951 B1**
(45) Date de publication et mention de la délivrance du brevet: **02.09.2026**
(21) Numéro de dépôt: 24187029.4
(22) Date de dépôt: 08.07.2024
(51) Int. Cl.: H10B 63/00, H10N 70/20

(54) **DISPOSITIF ÉLECTROCHIMIQUE DE STOCKAGE DE CHARGES ET SON PROCÉDÉ DE FABRICATION**
ELEKTROCHEMISCHE LADUNGSSPEICHERVORRICHTUNG UND EIN ENTSPRECHENDES HERSTELUNGSVERFAHREN
ELECTROCHEMICAL CHARGE STORAGE DEVICE AND A CORRESPONDING MANUFACTURING PROCESS

(30) Priorité: 10.07.2023 FR 2307355
(43) Date de publication de la demande: 15.01.2025
(73) Titulaire: Commissariat à l'Energie Atomique et aux Energies Alternatives, 75015 Paris (FR)
(72) Inventeur: OUKASSI, Sami, 38054 GRENOBLE CEDEX 09 (FR); HIRTZLIN, Tifenn, 38054 GRENOBLE CEDEX 09 (FR); MELFI, Massimiliano, 38054 GRENOBLE CEDEX 09 (FR); VIANELLO, Elisa, 38054 GRENOBLE CEDEX 09 (FR)
(74) Mandataire: Cabinet Camus Lebkiri

(56) Documents cités:
- WO-A1-2019/210156
- US-A1- 2017 323 945
- BOLUN WANG ET AL: "Bioelectronics-Related 2D Materials Beyond Graphene: Fundamentals, Properties, and Applications", ADVANCED FUNCTIONAL MATERIALS, WILEY - V C H VERLAG GMBH & CO. KGAA, DE, vol. 30, no. 46, 6 September 2020 (2020-09-06), pages n/a, XP072411923, ISSN: 1616-301X, DOI: 10.1002/ADFM.202003732

## Description

### DOMAINE TECHNIQUE DE L'INVENTION

Le domaine technique de l'invention est celui des composants de stockage, en particulier des composants électrochimiques de stockage de charges.

En particulier, l'invention concerne un dispositif électrochimique de stockage de charges pouvant être utilisé dans des applications neuromorphiques.

### ARRIERE-PLAN TECHNOLOGIQUE DE L'INVENTION

L'utilisation d'algorithmes d'intelligence artificielle pour un large éventail d'applications a explosé ces dernières années. Ces algorithmes nécessitent souvent des architectures dites neuromorphiques, qui visent à imiter le traitement synaptique qui se produit dans le cerveau humain. Ainsi, les architectures (ou circuits) neuromorphiques sont des circuits électroniques conçus pour émuler le comportement des neurones biologiques et des réseaux neuronaux.

Les architectures neuromorphiques, comme les unités de traitement résistives (RPU, pour « Resistive Processing Unit » en anglais) d'IBM^{™}, sont basées en partie sur des dispositifs de mémoires résistives qui utilisent un réseau d'éléments croisés pour obtenir de bonnes performances en termes de densité de mémoires, d'efficacité énergétique et de vitesse, en réduisant le mouvement des données pendant le calcul et en tirant parti d'états analogiques à plusieurs niveaux. De tels dispositifs de mémoires résistives peuvent accélérer la formation de réseaux neuronaux profonds en utilisant peu d'énergie. Il est en effet possible de reproduire le fonctionnement d'un neurone biologique en utilisant un réseau de mémoires résistives associées à des poids synaptiques respectifs.

Les dispositifs existants basés sur des filaments conducteurs ou sur des matériaux à changement de phase souffrent d'un bruit d'écriture excessif. Dans ces dispositifs, il est difficile de réduire le bruit et d'abaisser la tension de commutation tout en assurant la conservation des données à long terme, ce qui représente une limitation importante en termes de précision, d'efficacité énergétique et d'évolutivité de ces dispositifs. Pour mettre en œuvre des systèmes neuromorphiques efficaces, il est donc préférable d'utiliser des éléments de mémoire résistifs qui commutent à l'aide d'un mécanisme différent de celui utilisé dans les dispositifs à formation de filament ou à changement de phase.

C'est pourquoi, récemment, une nouvelle catégorie de composants a été étudiée pour ces applications neuromorphiques : le transistor ionique, qui peut être utilisé comme transistor synaptique. Le fonctionnement du transistor ionique est basé sur le déplacement d'ions entre la source et le drain, qui permet de modifier la valeur de conductance du transistor. Un tel transistor est notamment décrit dans l'article de Nguyen et al. « An Ultralow Power LixTiO2-Based Synaptic Transistor for Scalable Neuromorphic Computing », publié dans Advanced Electronic Materials en 2022. Les documents WO2019/210156A1 et US2017/323945A2 divulguent des dispositifs électrochimiques de stockage de charges comprenant un transistor ionique et une capacité ionique.

Le transistor ionique peut avantageusement être dans une pluralité d'états (plusieurs dizaines), chaque état correspondant à une valeur de conductance respective. Comme pour les mémoires résistives filamentaires ou à changement de phase, ces états sont non volatils : lorsqu'on cesse d'appliquer une tension de grille (bias) au transistor ionique, celui-ci conserve sa valeur de conductance. Or, pour certaines applications neuromorphiques, il est souhaitable que la valeur de conductance du transistor se « relaxe » au cours du temps, c'est-à-dire diminue au cours du temps, lorsqu'aucune tension de grille n'est appliquée. En outre, cette relaxation doit pouvoir être contrôlée.

L'invention vient améliorer la situation.

### RESUME DE L'INVENTION

L'invention offre une solution au problème évoqué précédemment, en proposant un dispositif électrochimique de stockage de charges (aussi appelé par la suite « dispositif électrochimique de stockage ») comprenant un transistor ionique et une capacité ionique, dans lequel la grille du transistor ionique est reliée, directement ou indirectement, à l'une des électrodes de la capacité ionique. Du fait de la présence de la capacité ionique, il est en effet observé une relaxation du niveau de conductance du transistor, lorsqu'aucune tension n'est appliquée à la grille. La valeur de la conductance du transistor décroit ainsi, avec une constante de temps qui peut être ajustée, notamment en appliquant une tension aux électrodes de la capacité ionique et en modulant la valeur de cette tension. Il est ainsi obtenu un dispositif présentant une multitude de niveaux de conductance, qui nécessite une très faible quantité d'énergie pour passer d'un niveau de conductance à un autre, et dont la conductance se relaxe avec le temps. Un tel dispositif simule de manière efficace le comportement d'une synapse biologique, et se révèle particulièrement intéressant dans la conception de systèmes neuromorphiques complexes et puissants.

En outre, il est possible de fabriquer un tel dispositif sur un même substrat, en mutualisant une grande partie des étapes de fabrication du transistor ionique et de la capacité ionique. Cela permet d'obtenir un dispositif compact dont la fabrication est relativement simple et peu coûteuse.

Un aspect de l'invention concerne ainsi un dispositif électrochimique de stockage de charges comprenant un transistor ionique et une capacité ionique,

le transistor ionique comprenant :
- une couche formant un réservoir d'ions, appelée couche réservoir ;
- une électrode de source en contact avec une partie de la couche réservoir ;
- une électrode de drain en contact avec une autre partie de la couche réservoir, l'électrode de drain et l'électrode de source étant physiquement séparées l'une de l'autre, l'électrode de source et l'électrode de drain étant chacune dans un matériau électriquement conducteur ; et
- une électrode de grille dans un matériau électriquement conducteur, l'électrode de grille étant séparée de la couche réservoir par une couche conductrice ionique dans un matériau conducteur ionique et diélectrique, la couche conductrice ionique étant en contact avec l'électrode de source et avec l'électrode de drain ;

la capacité ionique comprenant deux électrodes, chacune des deux électrodes étant dans un matériau électriquement conducteur, la capacité ionique comprenant une couche conductrice ionique séparant les deux électrodes de la capacité ionique, la couche conductrice ionique de la capacité ionique étant dans un matériau conducteur ionique et diélectrique ;

le dispositif comprenant en outre un élément de connexion apte à connecter l'électrode de grille du transistor ionique à une première électrode parmi les deux électrodes de la capacité ionique.

En d'autres termes, l'électrode de grille du transistor ionique est apte à être connectée à l'une des deux électrodes de la capacité ionique.

La couche réservoir est une couche dans un matériau comprenant des ions d'un certain type (par exemple Li+). La couche réservoir peut être dans un matériau dit « matériau d'insertion d'ions », ou « composé d'insertion » ou « matériau d'intercalation d'ions », i.e. un matériau qui permet la pénétration d'un certain type d'ions, sans altération de ses propriétés. Dans la suite, la couche réservoir est aussi appelée « couche de canal » ou « couche de matériau d'insertions d'ions ». Il est noté que, ci-dessus, un « matériau conducteur ionique » désigne un matériau conducteur pour les mêmes ions que ceux de la couche réservoir.

L'élément de connexion peut être n'importe quel composant électronique ou n'importe quel élément apte à connecter, au moins à un moment donné, l'électrode de grille du transistor ionique à la première électrode de la capacité ionique. Par exemple, l'élément de connexion peut être un élément en un matériau électriquement conducteur, comme un via conducteur ou une couche en un matériau conducteur (il est noté que lorsque rien n'est précisé, « conducteur » signifie « électriquement conducteur »), qui permet de connecter de manière simple le transistor ionique et la capacité ionique. L'élément de connexion peut, dans d'autres modes de réalisation, être un composant qui permet de contrôler les instants pendant lesquels la grille du transistor ionique est connectée à la première électrode la capacité ionique, comme un interrupteur ou un multiplexeur.

La « première électrode » désigne ici l'électrode de la capacité ionique qui peut être connectée, via l'élément de connexion, à l'électrode de grille. Cette terminologie est utilisée ici par souci de simplification de lecture. Il est entendu que l'électrode de grille du transistor ionique peut être connecté à n'importe laquelle des électrodes de la capacité ionique.

Il est noté que les termes « grille », « source », « drain » peuvent être utilisés à la place des termes « électrode de grille », « électrode de source », « électrode de drain », respectivement, par souci de simplification. Aussi, le terme « borne » peut être utilisé à la place de « électrode » pour la capacité ionique.

En l'absence d'une capacité ionique reliée à la grille du transistor ionique, ce dernier reste dans un état non volatil lorsqu'aucune tension n'est appliquée à sa grille. Cela signifie que lorsque le transistor ionique est dans un état correspondant à une certaine valeur de conductance, cette valeur reste sensiblement constante lorsqu'on cesse d'appliquer un courant de grille. En connectant la grille du transistor ionique à l'une des électrodes de la capacité ionique, il se produit une « décharge » partielle du transistor ionique dans la capacité ionique, qui se traduit par une diminution de la valeur de la conductance du transistor ionique au cours du temps, appelée ici « relaxation de l'état de conductance du transistor ionique ». Cette propriété est intéressante notamment dans le cadre des applications neuromorphiques, car elle reproduit plus fidèlement le comportement des synapses biologiques.

En outre, la réalisation d'un tel dispositif peut être avantageusement simplifiée car le transistor ionique et la capacité ionique utilisent des couches similaires de matériaux. Ainsi, certaines étapes de fabrication peuvent être mutualisées, comme détaillé ci-après.

Lorsque la capacité ionique a une structure « empilée » sur le substrat (dans le sens ou les électrodes s'étendent le long d'une direction qui correspond à la direction principale du substrat), la terminologie « électrode supérieure / électrode inférieure » peut être utilisée. L'électrode inférieure correspond à l'électrode la plus proche du substrat, tandis que l'électrode supérieure correspond à l'électrode la plus éloignée du substrat.

Dans un ou plusieurs modes de réalisation, l'une des électrodes parmi l'électrode de source et l'électrode de drain du transistor ionique est connectée à une deuxième électrode parmi les deux électrodes de la capacité ionique, la deuxième électrode étant distincte de la première électrode.

Ici, la « deuxième électrode » désigne l'autre électrode de la capacité ionique (i.e., celle qui n'est pas destinée à être connectée, via l'élément de connexion, à l'électrode de grille du transistor ionique). Par exemple, la deuxième électrode peut être l'électrode supérieure et la première électrode peut être l'électrode inférieure de la capacité ionique.

Dans un ou plusieurs modes de réalisation, l'élément de connexion est un élément apte à connecter, directement ou indirectement, l'électrode de grille du transistor ionique à la première électrode de la capacité ionique.

Par « directement », il est entendu qu'il n'y a pas de composant intermédiaire autre que l'élément de connexion entre le transistor ionique et la capacité ionique. A l'inverse, « indirectement » indique la présence d'un composant intermédiaire entre le transistor ionique et la capacité ionique, en plus de l'élément de connexion.

Dans un ou plusieurs modes de réalisation, l'élément de connexion peut être un élément parmi une couche en un matériau électriquement conducteur, un via conducteur, un interrupteur ou un multiplexeur.

Lorsque l'élément de connexion est une couche en un matériau électriquement conducteur ou un via conducteur, une même tension peut être appliquée à la grille du transistor ionique et aux bornes de la capacité ionique, ce qui permet à la fois de placer le transistor ionique dans un état de conductance donné et de modifier la valeur de capacitance de la capacité ionique. Ces deux actions se font donc de manière mutualisée.

Lorsque l'élément de connexion est un interrupteur ou un multiplexeur, il est possible de placer d'une part le transistor ionique dans un état de conductance donné et/ou de charger d'autre part la capacité ionique. Ces deux actions se font donc de manière séparée (ou en décalé), ce qui offre davantage de liberté sur le contrôle de la relaxation du transistor ionique. En particulier, cela permet d'introduire un délai contrôlé sur la relaxation (i.e. de contrôler le moment auquel on souhaite que la valeur de conductance du transistor ionique commence à décroître) et de maîtriser la vitesse de relaxation de l'état de conductance du transistor ionique. De manière schématique, la vitesse de relaxation dépend en partie de la valeur de capacitance de la capacité ionique : plus celle-ci est élevée, plus la relaxation est lente. La vitesse de relaxation dépend aussi en partie de la valeur de conductance du transistor ionique : plus celle-ci est élevée, plus la relaxation est rapide. En outre, il est possible d'interrompre ou de suspendre la relaxation en interrompant ou en suspendant la connexion entre la grille du transistor ionique et la première électrode de la capacité ionique.

Dans un ou plusieurs modes de réalisation, le dispositif comprend en outre la couche conductrice ionique du transistor ionique et la couche conductrice ionique de la capacité ionique sont communes.

Par « communes », il est entendu que le dispositif comprend une couche conductrice ionique « continue » (i.e. sans discontinuités, pour laquelle il n'y a pas d'interruption) qui joue à la fois le rôle de couche conductrice ionique du transistor ionique et de couche conductrice ionique de la capacité ionique.

En d'autres termes, selon ces modes de réalisation, la même couche conductrice ionique relie la source et le drain du transistor ionique et sépare les deux électrodes de la capacité ionique. Cela permet de mutualiser le dépôt d'une telle couche lors de la fabrication d'un dispositif selon l'invention.

Par exemple, le matériau conducteur ionique et diélectrique peut être un oxynitrure de phosphore de lithium LiPON, un oxynitrure de lithium-silicium-phosphore LiSiPON, un sulfure de phosphore de germanium de lithium LGPS, un oxyde de lithium lanthane zirconium LiLaZrₓO_{y} ou un oxyde de lithium lanthane tantale LiLaTaOₓ.

Le LiPON peut être utilisé pour un transistor ionique et une capacité ionique fonctionnant à base d'ions lithium Li+ (i.e. dont le fonctionnement repose sur la circulation d'ions Li+). Dans ces modes de réalisation, le canal du transistor ionique peut être réalisé dans un matériau d'insertion d'ions Li+, par exemple un oxyde de métal de transition pouvant intercaler des ions Li+. Bien entendu, l'invention s'applique à d'autres ions porteurs de charges, par exemple des ions Na+, H+, K+, Cu+, etc.

Le matériau électriquement conducteur dans lequel sont réalisées les électrodes de la capacité ionique et/ou les électrodes de source, drain ou grille du transistor ionique peut être, par exemple, un parmi : titane (Ti), tungstène (W), molybdène (Mo), nickel (Ni) ou platine (Pt).

La couche réservoir peut être réalisée, par exemple, dans l'un des matériaux suivants : dioxyde de titane (TiO₂), dioxyde de cobalt et de lithium (LiCoO₂), niobate de lithium (LiNbOₓ), trioxyde de tungstène (WO₃), oxyde de vanadium (VOₓ), oxyde de nickel (NiOₓ), oxyde de manganèse (MnOₓ) - et de manière générale des oxydes de métaux de transition, disulfure de molybdène (MoS₂), graphène.

Dans certains modes de réalisation, l'électrode de grille du transistor ionique et ladite première électrode de la capacité ionique peuvent être communes.

Par « communes », il est entendu que le dispositif comprend une couche « continue » (i.e. sans discontinuités, pour laquelle il n'y a pas d'interruption) de matériau électriquement conducteur qui joue à la fois le rôle d'électrode grille du transistor ionique et de première électrode de la capacité ionique. Par exemple, l'une des extrémités de la couche continue correspond à l'électrode de grille du transistor, et l'autre extrémité à l'électrode inférieure de la capacité.

Dans ces modes de réalisation, c'est donc une même couche de matériau électriquement conducteur qui fait à la fois office d'électrode de grille, d'élément de connexion et de première électrode de la capacité ionique. Cela permet une fabrication simplifiée du dispositif, mais aussi un dispositif plus compact.

Dans certains modes de réalisation alternatifs ou complémentaires des précédents, l'électrode de source du transistor ionique, l'électrode de drain du transistor ionique et la deuxième électrode de la capacité ionique peuvent être dans un même matériau électriquement conducteur et avoir une même épaisseur.

Le matériau électriquement conducteur peut être le même que celui de l'électrode de grille du transistor ionique et de la première électrode de la capacité ionique, mais ce n'est pas obligatoire.

En particulier, si l'électrode, parmi l'électrode de drain et l'électrode de source, du transistor ionique connectée à la deuxième électrode de la capacité ionique est appelée électrode de connexion du transistor ionique, alors l'électrode de connexion du transistor ionique et la deuxième électrode de la capacité ionique peuvent être communes.

En d'autres termes, le dispositif comprend une couche « continue » (i.e. sans discontinuités) qui joue à la fois le rôle d'électrode de connexion du transistor ionique et de deuxième électrode de la capacité ionique. Par exemple, l'une des extrémités de la couche continue correspond à l'électrode de connexion du transistor, et l'autre extrémité à la deuxième électrode de la capacité.

En d'autres termes, une même couche de matériau électriquement conducteur peut servir à la fois d'électrode de connexion (source ou drain) du transistor ionique et de deuxième électrode de la capacité ionique.

Dans des modes de réalisation, le transistor ionique et la capacité ionique peuvent être formés sur un même substrat, de manière monolithique.

Par « formés sur un même substrat », il est entendu que le transistor ionique et la capacité ionique sont intégrés sur une même plaque de substrat. Cela permet une co-intégration des deux composants en parallèle, avec des étapes de fabrication mutualisées. En particulier, au moins certaines couches sont issues d'une même couche de matériau déposée et structurée. On notera qu'on entend par substrat, le substrat brut (i.e. un wafer de Si par exemple) mais aussi un substrat brut sur lequel seraient déposées une ou plusieurs couches semiconductrices ou isolantes. Par « monolithique », il est entendu « d'un seul bloc ». En d'autres termes, le transistor ionique et la capacité ionique sont intégrés sur le même substrat et forment un ensemble.

Par exemple, le transistor ionique et la capacité ionique peuvent être montés sur un même niveau du substrat.

En particulier, le substrat peut comprendre, sur un premier niveau, des composants de type CMOS, et, sur deuxième niveau, le transistor ionique et la capacité ionique. Par exemple, la fabrication du transistor ionique et de la capacité ionique peut être faite en « Back End Of Line » sur un substrat intégrant des CMOS, sous réserve de respecter des températures maximales de l'ordre de 450°C.

Dans des modes de réalisation, le substrat peut comprendre un évidement, dans lequel au moins une partie de la capacité ionique est logée dans l'évidement.

Cela permet d'augmenter la surface d'échange entre les électrodes inférieure et supérieure de la capacité ionique, et donc la valeur de la capacitance de la capacité ionique.

Dans ces modes de réalisation, la deuxième électrode (électrode inférieure) de la capacité ionique s'étend le long d'une surface interne de l'évidement, la couche conductrice ionique de la capacité ionique recouvre au moins partiellement la deuxième électrode de la capacité ionique et la première électrode (électrode supérieure) de la capacité ionique recouvre au moins partiellement la couche conductrice ionique de la capacité ionique.

Dans des modes de réalisation, la capacité ionique comprend en outre une couche intercalaire dans un matériau réservoir d'ions, la couche intercalaire séparant la couche conductrice ionique de la capacité ionique et l'électrode, parmi les deux électrodes de la capacité ionique, autre que la première électrode.

Une telle implémentation permet d'augmenter davantage la valeur de la densité de capacitance (en pratique, celle-ci peut être doublée en comparaison avec une isoarchitecture sans couche intercalaire).

Un autre aspect de l'invention concerne un circuit de traitement neuromorphique de type « intégrateur de paires différentielles » comprenant un dispositif électrochimique de stockage de charges comme défini ci-avant.

Un circuit de type « intégrateur de paires différentielles », ou « differential pair integrator » en anglais (aussi appelé « diff-pair integrator ») est une synapse artificielle analogique décrite par exemple dans l'article de G. Indiveri et al. « Neuromorphic silicon neuron circuits », Frontiers in Neuroscience, publié le 31 mai 2011, ou dans l'article de M. Payvand et al. « Self-organization of an inhomogeneous memristive hardware for sequence learning », Nat Commun 13, 5793 (2022). Il est possible de remplacer les transistors ioniques de ces circuits par des dispositifs de stockage de charges selon l'invention, pour induire une relaxation de l'état de conductance des transistors ioniques et ainsi se rapprocher davantage du comportement des synapses biologiques. En outre, les capacités connectées aux transistors peuvent assurer le stockage des charges pour les autres blocs du circuit.

Un autre aspect de l'invention concerne un procédé de fabrication d'un dispositif électrochimique de stockage de charges comme défini précédemment, le procédé comprenant successivement :
- dépôt, sur un substrat, d'une première couche de matériau électriquement conducteur, et structuration de ladite première couche de sorte à obtenir une première partie de première couche et une deuxième partie de première couche n'ayant aucun point de contact, la première partie de première couche correspondant à une électrode parmi une électrode de source et une électrode de grille du transistor ionique, la deuxième partie de première couche correspondant à l'autre électrode parmi l'électrode de source et l'électrode de drain du transistor ionique et à une électrode de la capacité ionique ;
- dépôt de la couche réservoir, la couche réservoir étant en contact avec la première partie de première couche et avec la deuxième partie de première couche ;
- dépôt d'une couche conductrice ionique dans un matériau conducteur ionique et diélectrique, la couche conductrice ionique recouvrant au moins partiellement la première partie de première couche, toute la couche réservoir et au moins partiellement la deuxième partie de première couche ; et
- dépôt d'une deuxième couche de matériau électriquement conducteur recouvrant au moins partiellement la couche conductrice ionique, la deuxième couche de matériau électriquement conducteur n'ayant aucun point de contact physique avec la première couche de matériau électriquement conducteur, la deuxième couche de matériau électriquement conducteur formant une électrode de grille du transistor ionique et une autre électrode de la capacité ionique.

**Il** est ainsi possible de fabriquer un dispositif électrochimique de stockage de façon monolithique sur un même substrat, en mutualisant certaines étapes pour fabriquer à la fois les éléments composant le transistor ionique et les éléments composant la capacité ionique. Ceci est rendu possible par le fait que le transistor ionique et la capacité ionique sont composés de couches de matériau similaires. Il en résulte une simplicité de fabrication, et un dispositif électrochimique de stockage compact et adapté à des applications neuromorphiques.

En particulier, le dépôt d'au moins une couche parmi la première couche de matériau électriquement conducteur, la couche conductrice ionique et la deuxième couche de matériau électriquement conducteur peut être un dépôt conforme.

Par « dépôt conforme », il est entendu un dépôt épousant la surface sur laquelle la couche de matériau est formée et ayant une même épaisseur sur toute sa surface de dépôt.

Préalablement aux étapes ci-dessus, le procédé peut comprendre : structuration du substrat pour former un évidement dans le substrat, dans lequel les dépôts de la première couche de matériau électriquement conducteur, de la couche conductrice ionique et de la deuxième couche de matériau électriquement conducteur se font successivement sur le substrat ainsi structuré.

Ainsi, une unique couche peut être déposée puis structurée pour former plusieurs éléments du dispositif de stockage électrochimique d'énergie selon l'invention.

L'invention et ses différentes applications seront mieux comprises à la lecture de la description qui suit et à l'examen des figures qui l'accompagnent.

### BREVE DESCRIPTION DES FIGURES

D'autres caractéristiques et avantages de l'invention apparaîtront à la lecture de la description, qui peut être lue en regard des figures. Ces figures sont présentées à titre indicatif et nullement limitatif de l'invention.
[Fig. 1a], [Fig. 1b] Les Figures 1a et 1b représentent un transistor ionique de l'état de la technique.
[Fig. 2a], [Fig. 2b] Les Figures 2a et 2b représentent une capacité ionique de l'état de la technique.
[Fig. 3a] La Figure 3a représente un exemple d'un montage électronique permettant une relaxation de la valeur de conductance d'un transistor ionique selon un mode de réalisation de l'invention.
[Fig. 3b] La Figure 3b représente une modélisation équivalente du montage électronique de la Figure 3a.
[Fig. 4a], [Fig. 4b], [Fig. 4c], [Fig. 4d], [Fig. 4e], [Fig. 4f] Les Figures 4a à 4f illustrent des étapes d'un procédé de fabrication d'un élément de stockage selon un mode de réalisation de l'invention.
[Fig. 5] La Figure 5 représente un exemple d'ordinogramme d'un procédé de fabrication d'un élément de stockage selon un mode de réalisation de l'invention.
[Fig. 6] La Figure 6 représente un exemple d'ordinogramme d'un procédé d'utilisation d'un élément de stockage selon un mode de réalisation de l'invention.
[Fig. 7] La Figure 7 représente plusieurs courbes illustrant la relaxation de la conductance normalisée du transistor ionique en fonction du temps, pour plusieurs valeurs de la capacité ionique.
[Fig. 8] La Figure 8 représente un exemple d'un élément de stockage selon un autre mode de réalisation de l'invention.

### DESCRIPTION DETAILLEE

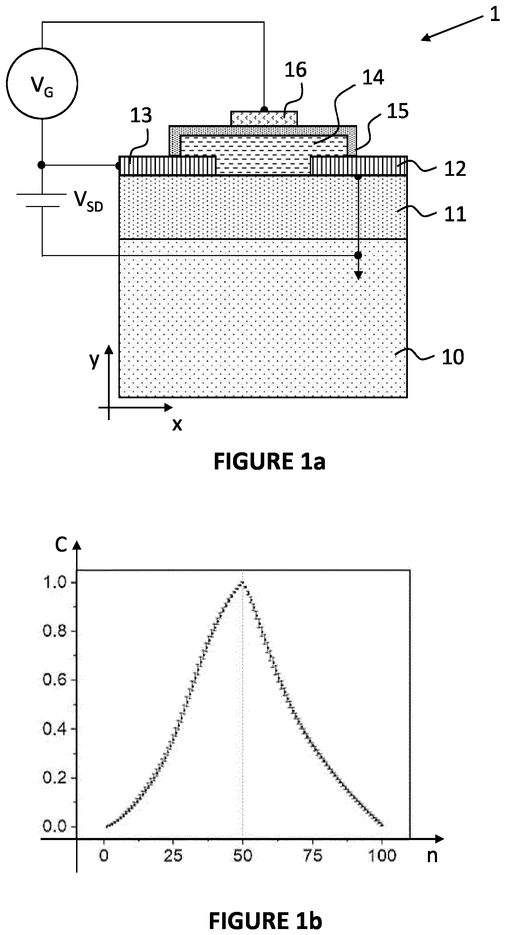

La Figure 1a représente un transistor ionique 1 selon l'état de la technique.

Le transistor ionique 1 est un transistor analogique monté sur un substrat 10, notamment en silicium Si, recouvert d'une couche 11 de matériau diélectrique (par exemple, du dioxyde de silicium SiO₂), qui comprend un canal 14 de conductivité électrique variable, une électrode de source 13 (aussi appelée simplement « source ») et une électrode de drain 12 (aussi appelée simplement « drain »). Il est noté que dans certains modes de réalisation l'ensemble formé par le substrat 10 et la couche 11 de diélectrique peut être remplacé par une couche unique de matériau diélectrique. Le drain 12 et la source 13 sont séparés l'un de l'autre par le canal 14, de sorte que le drain 12 et la source 13 n'ont aucun point de contact physique. Par exemple, le drain 12 et la source 13 peuvent être déposés sur deux portions d'une surface de la couche 11 de matériau diélectrique, les deux portions de la surface de la couche 11 de matériau diélectrique étant espacées l'une de l'autre de, par exemple, quelques dizaines de nanomètres. Le drain 12 et la source 13 sont dans un matériau électriquement conducteur. Le canal 14 est dans un matériau d'insertion d'ions. Il est noté que les électrodes de source et de drain peuvent être interchangées (en particulier, sur la Figure 1a, l'électrode 12 peut représenter la source et l'électrode 13 peut représenter le drain).

Le transistor ionique 1 comprend en outre une couche 15 d'un matériau à la fois conducteur ionique et diélectrique, séparant le canal 14 d'une électrode 16 appelée grille, positionnée à la surface supérieure de la couche 15 de matériau à la fois conducteur ionique et diélectrique. L'électrode de grille 16 (aussi appelée simplement « grille ») est dans un matériau électriquement conducteur. La couche 15 permet donc le transport d'ions entre le canal 14 et l'électrode de grille 16, mais bloque le transport des électrons. Il est entendu que la couche 15 est conductrice pour les mêmes ions que le matériau d'insertions d'ions composant le canal 14. Par exemple, si le canal 14 est dans un matériau permettant l'intercalation d'ions Li+, le matériau de la couche 15 est conducteur pour les ions Li+.

Le transistor ionique 1 peut être fabriqué en déposant (et en structurant) successivement les couches qui le composent (dépôt des couches formant le drain 12 et la source 13, puis dépôt de la couche 14 formant le canal, puis dépôt de la couche 15 de matériau conducteur ionique et diélectrique, et enfin dépôt de la couche 16 formant l'électrode de grille 16), par exemple par un procédé de lithographie (comme une photolithographie ou une lithographie électronique).

Le canal 14 est dans un matériau d'insertion d'ions, dont la conductivité électrique dépend de son niveau d'oxydation. Par exemple, le canal peut être dans un matériau inerte tel que des composants lithiés comme LiₓCoO₂, LiₓNiO₂, LiₓMn₂O₄, LiₓV₂O₅, LiₓWO₃, LiₓMO₃, LiₓTi₅O₁₂, où x est la fraction de lithium dans le composant.

De manière non limitative, le canal 14 peut comprendre du LiCoO₂, la couche 15 de matériau conducteur ionique et diélectrique peut comprendre de l'oxynitrure de phosphore de lithium (LiPON), qui est un matériau qui peut conduire les ions Li+ du canal 14.

Il est noté que d'autres couches peuvent être ajoutées au transistor ionique 1, par exemple une couche intercalaire en un matériau d'insertion d'ions située entre la couche de canal 14 et la couche 15 de matériau conducteur ionique et diélectrique. En outre, il est noté que la structure du transistor ionique peut différer de l'exemple représenté sur la Figure 1a. Par exemple, selon certaines réalisations, la couche de canal 14 peut recouvrir intégralement le drain 12 et la source 13, comme dans la demande US 10,429,343 par exemple.

Le niveau d'oxydation du canal 14 peut être modifié en appliquant une tension V_{G} appliquée entre la grille 16 et la source 13. Lorsqu'une tension V_{G} est appliquée entre la grille 16 et la source 13, cela induit une migration des ions entre la grille 16 et le canal 14, ce qui a pour effet de modifier la conductance électrique du canal 14 entre la source 13 et le drain 12, et donc l'état logique du transistor, un état logique étant associé à une valeur de conductance électrique respective du transistor. Les différentes valeurs de conductance (normalisées) du transistor ionique en fonction de la tension appliquée entre la grille 16 et la source 13 sont représentées sur la Figure 1b. Par conductance du transistor ionique, il est entendu la conductance électrique du canal 14.

Pour obtenir la courbe de la Figure 1b, des impulsions de tension successives ont été appliquées entre la grille 16 et la source 13. Sur l'exemple de la Figure 1b, chaque impulsion de tension a une amplitude de ±100 mV et une largeur de 0.1 seconde. Ces valeurs sont fournies à titre d'exemple et de manière non limitative. La courbe de la Figure 1b représente la variation de la conductance du transistor (en ordonnées) en fonction du numéro n d'impulsion de tension (en abscisses). Pour obtenir la courbe de la Figure 1b, 50 impulsions successives d'amplitude négative ont été appliquées (partie croissante de la courbe, appelée phase de potentialisation), puis 50 impulsions successives d'amplitude positive ont été appliquées (partie décroissante de la courbe, appelée phase de dépression).

Il apparaît de la Figure 1b que la conductance du canal 14 peut être modifiée de manière réversible selon la tension V_{G} appliquée entre la grille 16 et la source 13. En outre, la variation de la valeur de la conductance est linéaire pendant l'application d'une valeur constante non nulle de la tension. Elle croît de manière linéaire lorsqu'un créneau de tension d'amplitude négative est appliquée, et elle décroît de manière linéaire lorsqu'un créneau de tension d'amplitude positive est appliquée. En outre, l'application d'un créneau de tension d'amplitude positive « annule » les effets de l'application d'un créneau de tension de même durée et d'amplitude opposée (et réciproquement), en ce sens où elle ramène la valeur de la conductance à la valeur initiale.

Il est ainsi possible de modifier la conductance du transistor ionique 1 de la Figure 1a en jouant sur la valeur de la tension V_{G} appliquée entre la grille 16 et la source 13. Une fois que le transistor ionique a une certaine valeur de conductance, une tension V_{SD} est appliquée entre la source 13 et le drain 12 et un courant circule, la valeur de l'intensité du courant étant fixée par la valeur de conductance du transistor.

Les différentes valeurs de conductance associées aux différents numéros d'impulsion de courant correspondent à des états logiques (ou « états de conductance »). Chaque état logique est non volatil, et la transition d'un état logique à l'état suivant nécessite une très faible énergie (par exemple, une quantité d'énergie par surface active de l'ordre du fJ/µm²). En outre, comme cela apparaît sur la Figure 1b, un grand nombre (plusieurs dizaines) d'états logiques peuvent être atteints en potentialisation et en dépression de manière contrôlée (par le biais de la tension appliquée V_{G}), avec, comme mentionné ci-dessus, une linéarité de réponse qui est fonction de la plage de conductance considérée.

Il est noté que la vitesse de transition entre deux états logiques successifs du transistor ionique dépend en partie de l'épaisseur de la couche de canal 14 (l'épaisseur correspondant à la dimension selon l'axe y sur la Figure 1a) : plus la couche de canal 14 est fine, plus la vitesse de transition entre deux états logiques successifs est élevée. L'épaisseur de la couche de canal 14 peut être ainsi fixée, par exemple, entre 1 et 500 nm.

La vitesse de transition entre deux états logiques successifs dépend aussi en partie de l'épaisseur de la couche 15 de matériau conducteur ionique et diélectrique : plus la couche 15 de matériau conducteur ionique et diélectrique est fine, plus la vitesse de transition entre deux états logiques successifs est élevée. L'épaisseur de la couche 15 de matériau conducteur ionique et diélectrique peut être ainsi fixée, par exemple, entre 1 et 200 nm.

Comme détaillé ci-dessus, le transistor ionique est un transistor analogique permettant plusieurs dizaines d'états (ce qui est aujourd'hui difficile à obtenir à partir de transistors diélectriques et avec des mémoires résistives), ce qui en fait un composant de choix pour reproduire le fonctionnement des synapses, qui, dans le cerveau humain, permettent de connecter les neurones entre eux. Dans le cerveau humain, les neurones se mettent en action lorsque les synapses ont totalisé un certain nombre d'impulsions électriques, ce qui est rendu possible par un transistor à plusieurs dizaines d'états.

En outre, le transistor ionique exploite la même réaction électrochimique qu'une synapse, ce qui lui confère une excellente efficacité énergétique, du même ordre de grandeur qu'une synapse de cerveau humain.

Ces propriétés font du transistor ionique un composant particulièrement adapté pour les applications neuromorphiques. Toutefois, une limitation demeure pour ces transistors : la constante de temps, qui définit de façon générale la relaxation d'un état logique du transistor dans le temps et sans bias (c'est-à-dire lorsqu'aucune tension de grille n'est appliquée). Chaque état logique étant non volatil, la constante de temps n'est pas adaptable ou contrôlable, ce qui réduit le domaine d'applications pour ces composants.

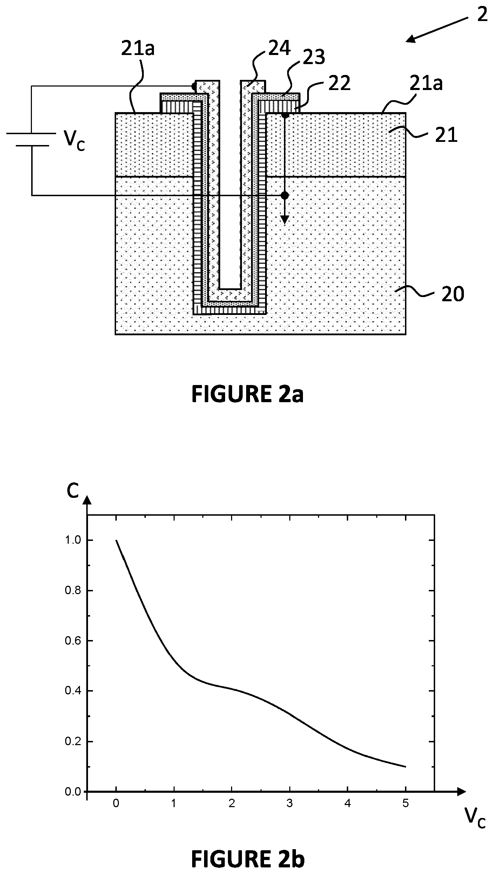

La Figure 2a représente une capacité ionique 2 (aussi appelée supercondensateur) selon l'état de la technique.

Une capacité ionique est un composant de stockage électrochimique d'énergie, de type supercondensateur, composé de matériaux exclusivement sous forme solide. Une capacité ionique peut être chargée et déchargée en la connectant à un circuit électrique. Le stockage de l'énergie se fait grâce aux modifications des matériaux qui composent la capacité ionique au cours des charges et des décharges. En effet, lorsqu'une tension est appliquée aux bornes de la capacité ionique, des déplétions / concentrations d'ions se produisent au niveau des deux interfaces conducteur ionique / électrode.

Comme représenté sur la Figure 2a, une capacité ionique 2 comprend typiquement un substrat 20 recouvert d'une première couche 21 de diélectrique. Le substrat 20 est un substrat brut (c'est-à-dire non traité), ou il peut avoir déjà subi un traitement de sorte que d'autres composants électroniques ou couches sont déjà présents sur celui-ci. Sur l'exemple de la Figure 2a, le substrat 20 et la couche 21 de diélectrique de la Figure 2a sont traversés par une cavité recouverte d'une couche 22 de matériau électriquement conducteur. La cavité est ici un trou borgne dont le fond est situé au niveau de substrat 20, à proximité de la surface inférieure du substrat 20. Cette couche 22 de matériau électriquement conducteur recouvre au moins partiellement la surface « libre » 21a de la première couche 21 de diélectrique (i.e. la surface 21a qui n'est pas contre le substrat 20 et qui n'est pas le long de la cavité formée) de part et d'autre de la cavité. La couche 22 de matériau électriquement conducteur forme l'une des électrodes de la capacité ionique 2, appelée ici électrode inférieure (en anglais, « bottom electrode »). La couche 22 de matériau électriquement conducteur est recouverte (au moins partiellement) d'une couche 23 d'un matériau à la fois conducteur ionique et diélectrique (diélectrique ionique). Cette couche 23 de conducteur ionique est recouverte (au moins partiellement) d'une couche 24 de matériau électriquement conducteur, qui forme l'autre électrode de la capacité ionique 2, appelée électrode supérieure (en anglais, « top electrode »). L'électrode inférieure 22 et l'électrode supérieure 24 sont donc isolées électriquement l'une de l'autre par la couche 23, qui permet toutefois aux ions de circuler entre les deux électrodes 22 et 24.

Il est noté que l'exemple représenté à la Figure 2a n'est pas limitatif et que d'autres configurations sont possibles. Par exemple, dans certaines configurations, la cavité ne traverse que la première couche 21 de diélectrique. En outre, la forme de la cavité n'est pas limitative, et peut être remplacée par un pore dans une couche 21 de diélectrique poreuse, tel que décrit dans la demande EP3570307.

Dans l'exemple de la Figure 2a, l'électrode inférieure 22, la couche de diélectrique ionique 23 et l'électrode supérieure 24 de la capacité ionique 2 sont disposées selon une structure MIM (métal - isolant - métal) dans lequel l'isolant est un diélectrique conducteur d'ions (diélectrique ionique), mais d'autres configurations sont possibles, par exemple une configuration MOIM (métal - oxyde - diélectrique ionique - métal) dans laquelle une couche d'oxyde est intercalée entre l'électrode inférieure et la couche de diélectrique ionique, comme dans la demande EP3570307.

La présence de la cavité dans l'ensemble formé du substrat 20 et de la couche 21 de diélectrique de la Figure 2a n'est pas obligatoire, mais elle permet avantageusement d'augmenter la surface effective d'accumulation des charges entre les deux électrodes 22 et 24. En outre, il est noté que la capacité ionique 2 peut être formée selon une configuration planaire ou tridimensionnelle, une configuration tridimensionnelle permettant avantageusement d'augmenter la surface effective d'accumulation des charges entre les deux électrodes par unité de surface géométrique sur substrat, et donc d'augmenter la densité de capacité de la capacité ionique 2 (en jouant uniquement sur la géométrie de la capacité ionique).

L'application d'une tension Vc entre l'électrode inférieure 22 et l'électrode supérieure 24 induit deux phénomènes physiques distincts : d'une part, l'établissement d'une double couche électrochimique entre le conducteur ionique 23 et les deux électrodes 22 et 24 (apparition d'une capacitance ionique), et d'autre part, la polarisation diélectrique du conducteur ionique 23 (apparition d'une capacitance diélectrique). La combinaison de ces deux phénomènes confère à la capacité ionique une densité de puissance par unité de surface très élevée, de l'ordre de quelques dizaines de µF/mm², c'est-à-dire de plusieurs ordres de grandeur supérieure aux densités de puissance des composants diélectriques de type MOS ou MIM.

En outre, comme représenté sur la Figure 2b, la valeur de la capacitance ionique de la capacité 2 est variable et dépend de la tension Vc appliquée aux bornes de celle-ci (i.e. entre les deux électrodes 22 et 24). Lorsque la tension appliquée aux bornes de la capacité ionique 2 augmente, la valeur de la capacitance diminue au cours du temps, depuis une valeur dite « nominale » jusqu'à une valeur de capacitance de l'ordre de 10% de la valeur nominale. Par ailleurs, la capacité ionique 2 s'autodécharge lorsqu'aucune tension n'est appliquée à ses bornes. En ce sens, l'état de charge de la capacité ionique 2 peut être considéré comme volatil.

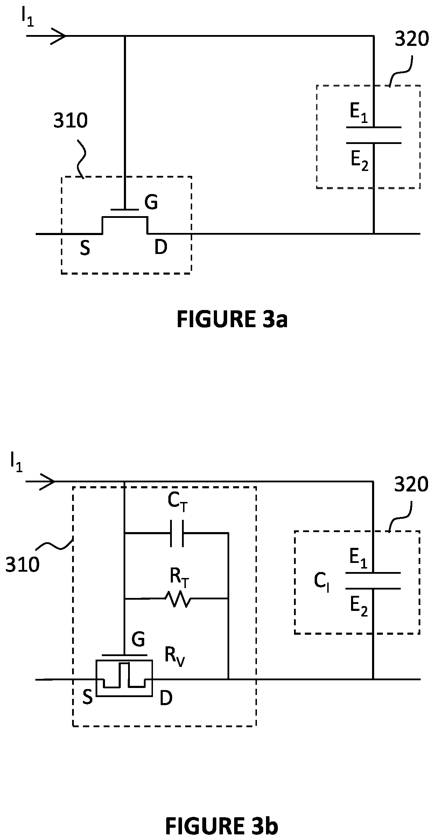

La Figure 3a représente un exemple d'un montage électronique permettant une relaxation de la valeur de conductance d'un transistor ionique selon un mode de réalisation de l'invention.

Le montage de la Figure 3a comprend un transistor ionique 310 et une capacité ionique 320, dans lequel la grille G du transistor ionique 310 est connectée à une électrode E₁ de la capacité ionique 320. En outre, sur l'exemple de la Figure 3a, le drain D du transistor ionique 310 est connecté à l'autre électrode E₂ de la capacité ionique 320. Il est noté que le drain et la source sont interchangeables. Ainsi, il est possible de connecter la source S du transistor ionique 310 à l'autre électrode E₂ de la capacité ionique 320 (la grille G du transistor ionique 310 étant toujours connectée à l'électrode E₁ de la capacité ionique 320). Dans le cas d'une capacité ionique ayant une structure « en U » comme sur la Figure 2a, les électrodes E1 et E2 peuvent correspondre de manière interchangeable à l'électrode supérieure et à l'électrode inférieure de la capacité ionique.

Sur l'exemple de la Figure 3a, une même tension est appliquée à la grille G du transistor ionique 310 et aux bornes de la capacité ionique 320. Il est ainsi possible de placer le transistor ionique 310 dans un état de conductance donné, et en même temps de modifier la valeur de la capacitance de la capacité ionique 320. Il est noté que cela n'est pas obligatoire.

Par exemple, le transistor ionique 310 et la capacité ionique 320 peuvent être séparés par un dispositif intermédiaire, tel qu'un multiplexeur ou un interrupteur, qui permet de connecter la grille G du transistor ionique 310 à l'électrode E₁ de la capacité ionique 320 uniquement à un moment donné. Un tel dispositif intermédiaire permet de contrôler le moment où la grille G du transistor ionique 310 est connectée à l'une des électrodes de la capacité ionique 320 (et ainsi de permettre qu'à d'autres moments, la grille G du transistor ionique 310 ne soit pas connectée à une électrode de la capacité ionique 320). Ainsi, il est possible de placer le transistor ionique 310 dans une certaine valeur de conductance et/ou la capacité ionique 320 dans une certaine valeur de capacitance avant de connecter la grille G du transistor ionique 310 à l'une des électrodes de la capacité ionique 320. Cela permet de conserver la possibilité de maintenir le transistor ionique dans un certain état non volatil, et de contrôler l'instant auquel on souhaite que cet état commence à se relaxer. En d'autres termes, cela introduit un délai supplémentaire pour la relaxation de la valeur de conductance du transistor ionique 310.

En outre, la constante de temps représentative de la vitesse de relaxation de la valeur de la conductance du transistor dépend en partie de la conductance du transistor ionique 310 et de la valeur de la capacité ionique. Aussi, en modifiant la valeur de conductance du transistor ionique 310 et/ou la valeur de la capacité ionique 320 (avant de relier la grille du transistor ionique 310 à l'une des électrodes de la capacité ionique 320), il est possible de moduler cette constante de temps, et donc la vitesse de relaxation de la conductance du transistor ionique 310.

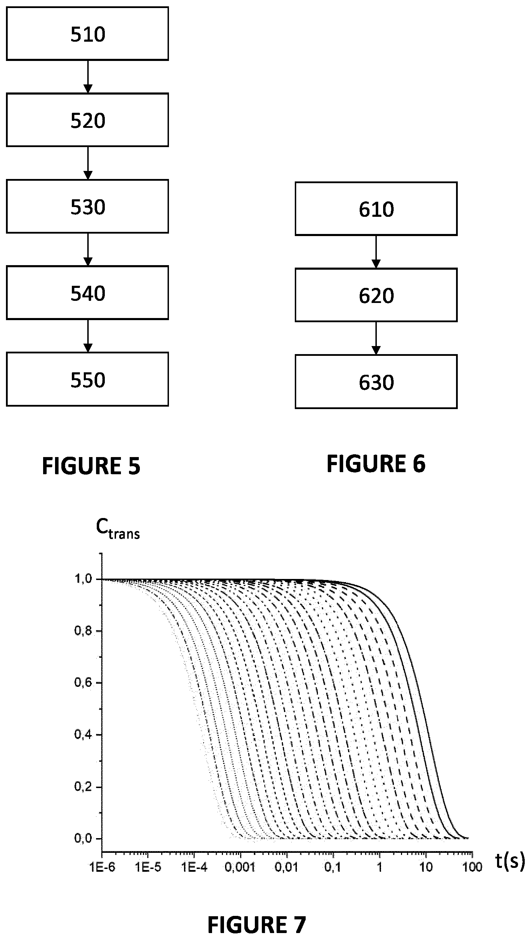

Dans un ou plusieurs modes de réalisation, le fonctionnement de l'élément de stockage électrochimique de charges 36 peut donc comprendre les étapes suivantes, représentées à la Figure 6 :
- étape d'écriture :
   - un premier signal électrique (tension ou courant) est appliqué (étape 610) entre la source et la grille du transistor ionique 310 pour que celui-ci entre dans un état de conductance donné ; et
   - un deuxième signal électrique (tension ou courant) est appliqué (étape 620) entre les deux électrodes de la capacité ionique 320 ;
- étape de lecture : la source ou le drain du transistor ionique 310 est connecté à l'une des électrodes de la capacité ionique 320, tandis que la grille du transistor ionique 310 est connectée à l'autre électrode de la capacité ionique 320 (étape 630).

Comme mentionné ci-dessus, le premier signal électrique et le deuxième signal électrique peuvent être les mêmes, comme sur le schéma de la Figure 3a (courant I₁). Le premier signal électrique et le deuxième signal électrique peuvent également être deux signaux électriques différents appliqués indépendamment au transistor ionique 310 d'une part (premier signal électrique), et à la capacité ionique 320 d'autre part (deuxième signal électrique). Quand les deux signaux électriques sont différents, ils peuvent être appliqués de manière simultanée ou non (dans ce dernier cas, ils peuvent être appliqués à deux instants distincts dans le temps ou pendant deux intervalles de temps distincts, qui peuvent se recouper ou non).

La Figure 3b représente une modélisation simplifiée d'un schéma électrique équivalent au montage électronique de la Figure 3a. Sur cette modélisation, le transistor ionique comprend une résistance variable Rv, ainsi qu'une résistance R_{T} et une capacité C_{T}, la résistance R_{T} et la capacité C_{T} étant toutes deux connectées à la grille G via l'une de leurs bornes, et au drain D via l'autre de leurs bornes. La résistance R_{T} correspond à la résistance ionique du transistor, due à la migration des ions depuis la grille vers le canal. La capacité C_{T} correspond à la capacité géométrique du transistor ionique, c'est-à-dire la capacité « diélectrique » du transistor ionique 310.

Grâce à la connexion de la grille du transistor ionique 310 à une électrode de la capacité ionique 320, il se produit une « décharge » partielle du transistor ionique 310 vers la capacité ionique 320. Cela se traduit par une relaxation de la valeur de la conductance du transistor ionique 310, comme représenté sur la Figure 7.

Les courbes de la Figure 7 ont été obtenues par simulation, en utilisant la modélisation équivalente approximée de la Figure 3b, une fois que le transistor ionique est dans un état de conductance donné (et qu'aucune tension de grille n'est appliquée). Plus précisément, plusieurs jeux de courbes sont représentés sur la Figure 3b (chaque jeu de courbe étant représenté par un même type de trait, par exemple un trait plein, un trait discontinu, une suite de points plus ou moins rapprochés, une alternance d'un ou plusieurs tirets et d'un ou plusieurs points, etc.). Chaque jeu de courbes correspond respectivement à une même valeur nominale de capacitance totale, la capacitance totale étant la somme des capacitances de la capacité C_{T} du transistor ionique et de la capacité ionique C_{I}. Pour obtenir les différentes courbes d'un même jeu de courbes, la valeur de la capacitance ionique C_{I} a été modulée en appliquant une ou plusieurs valeurs de tension aux bornes de la capacité ionique (comme expliqué ci-dessus en référence à la Figure 2b, la valeur de la capacitance de la capacité ionique varie en fonction de la tension appliquée aux bornes de la capacité ionique).

Les courbes de la Figure 7 illustrent la relaxation de la conductance du transistor ionique au cours du temps : la valeur de la conductance diminue avec le temps. Ainsi, il apparaît que la connexion d'une électrode d'une capacité ionique à la grille du transistor ionique induit une volatilité de l'état de conductance du transistor ionique.

En outre, les courbes de la Figure 7 illustrent le fait que la vitesse de relaxation dépend de la valeur de la capacitance totale. Il est ainsi possible de jouer sur la valeur de la capacitance totale (notamment en modulant la valeur de la capacitance ionique en appliquant une tension aux bornes de la capacité ionique) pour modifier la vitesse de relaxation de la conductance du transistor ionique.

Comme mentionné précédemment, le transistor ionique et la capacité ionique sont deux composants qui utilisent des couches communes dans leur fonctionnement (notamment les couches actives 15 et 23 conductrices d'ions et les couches formant les électrodes 12, 13, 16, 22, 24). Cela rend possible la réalisation d'un élément de stockage présentant les caractéristiques du circuit de la Figure 3a par cointégration d'un transistor ionique et d'une capacité ionique sur un même substrat, dans lequel certaines étapes de fabrication des deux composants sont mutualisées.

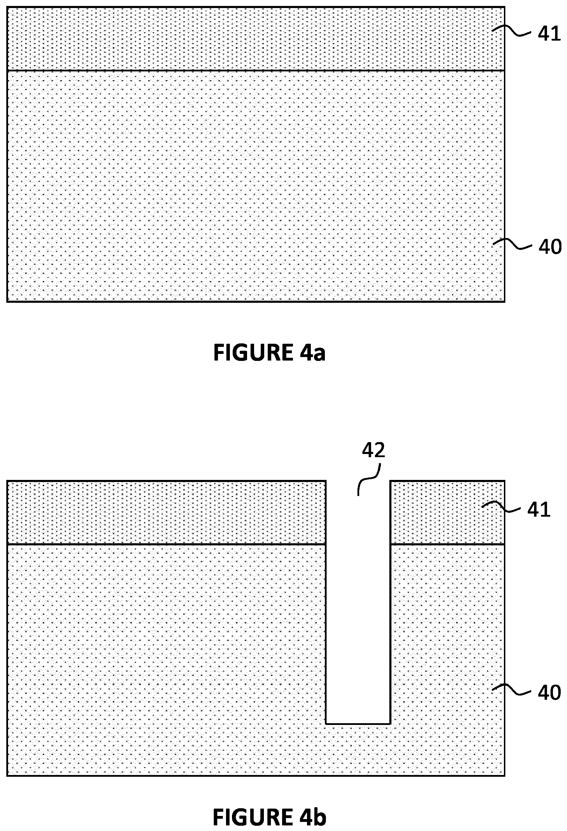

Il est ainsi possible de réaliser un élément de stockage ayant les mêmes caractéristiques que le circuit représenté à la Figure 3a par dépôt de couches successives, comme décrit maintenant en référence aux Figures 4a à 4f.

Les Figures 4a à 4f illustrent des étapes d'un procédé de fabrication d'un élément de stockage selon un mode de réalisation de l'invention. L'ordinogramme de ce procédé de fabrication est représenté à la Figure 5.

Lors d'une première étape 510 (Figure 5) du procédé, une couche isolante électrique peut être déposée sur un substrat. Cette étape est illustrée sur la Figure 4a.

Comme représenté sur la Figure 4a, une couche 41 isolante électrique (par exemple en un matériau diélectrique) est formée sur un substrat 40, par exemple par un procédé de dépôt pleine plaque. Le substrat 40 peut être une plaque de matériau semiconducteur. Dans certains modes de réalisation, cette plaque intègre un ou plusieurs composants tels que des transistors classiques ou des microsystèmes. En particulier, l'intégration du dispositif de stockage de la présente invention peut être fait en « Back End Of Line », c'est-à-dire après la réalisation du niveau CMOS et dans des niveaux supérieurs, au même titre que les contacts. Il est noté que la couche conductrice ionique 41 peut constituer à elle seule le substrat (dans certains modes de réalisation donc, il peut n'y avoir qu'une couche diélectrique 41 qui remplace les deux couches 40 et 41 des Figures 4a à 4f).

La couche diélectrique 41 peut être composée d'un ou plusieurs matériaux permettant une isolation électrique, par exemple un oxyde, un nitrure, un oxynitrure, ou tout matériau ou combinaison de matériau pouvant faire office de passivation chimique et électrique entre le substrat 40 et l'élément mémoire.

Dans un mode de réalisation non limitatif, le substrat 40 peut être une plaque de silicium et la couche 41 peut être une couche d'oxyde de silicium.

En outre, lors de la première étape 510 du procédé représenté à la Figure 5, l'ensemble composé du substrat et de la couche conductrice ionique peut être structuré pour former un évidement destiné à recevoir la capacité ionique. Cette structuration est représentée sur la Figure 4b.

Comme représenté à la Figure 4b, l'ensemble « substrat 40 / couche diélectrique 41 » peut être structuré pour créer une ouverture 42 (ou « cavité » ou « sillon ») perpendiculairement au plan de surface de la couche diélectrique 41 et du substrat 40. Cette structuration est réalisée à travers la couche diélectrique 41 et le substrat 40, et s'arrête dans le volume de substrat sans le traverser. Sur l'exemple de la Figure 4b, l'ouverture 42 est un trou borgne dans la couche diélectrique 41 qui traverse une partie du substrat 40, et dont le fond est situé à proximité de la surface inférieure du substrat 40. Il est noté que selon les modes de réalisation, l'ouverture 42 peut traverser le substrat selon une profondeur variable, voire ne traverser que tout ou partie de la couche diélectrique 41 (et donc ne pas traverser le substrat 40). Dans certains modes de réalisation, la structuration peut être effectuée par une technique de photolithographie (comprenant typiquement un dépôt d'une couche de résine par enduction centrifuge - ou « spin coating » en anglais sur l'ensemble « substrat 40 / couche diélectrique 41 », une insolation à travers un masque et un développement de la résine insolée) suivie d'une gravure plasma.

Comme mentionné en référence à la Figure 2a, la présence de l'ouverture 42 n'est pas obligatoire, mais elle permet avantageusement d'augmenter la surface effective d'accumulation des charges entre les deux électrodes 43b et 47b.

En référence à nouveau à la Figure 5, lors d'une étape 520, une première couche d'un matériau électriquement conducteur peut être déposée sur la surface du substrat, et structurée en deux parties n'ayant aucun point de contact, l'une faisant office d'électrode de source au transistor ionique, et l'autre comprenant à la fois d'électrode de drain et l'électrode inférieure de la capacité ionique.

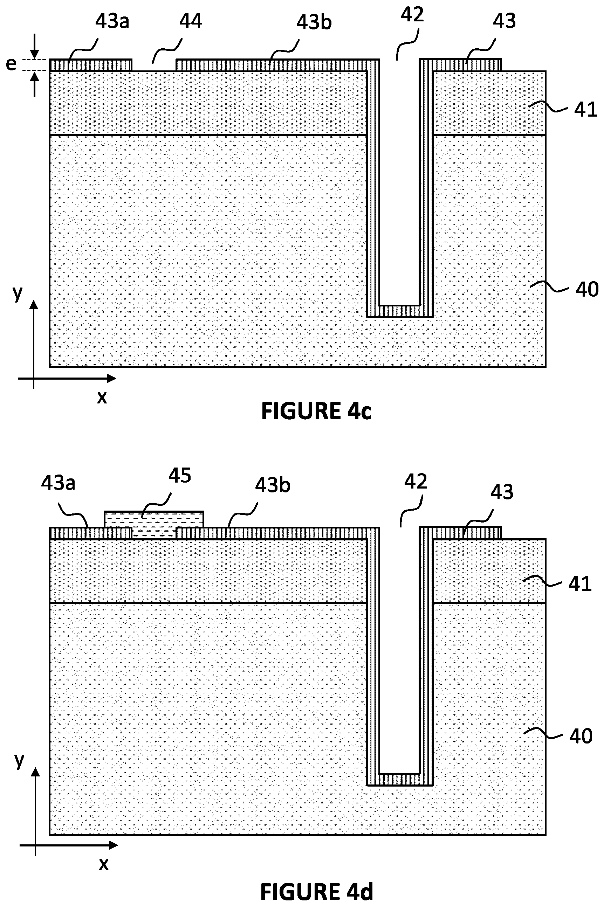

Cette étape 520 est représentée sur la Figure 4c : une couche 43 de matériau électriquement conducteur est formée sur une partie de la surface de la couche diélectrique 41 et au niveau de l'ouverture 42 le cas échéant. La couche 43 de matériau électriquement conducteur comprend deux parties 43a, 43b séparées d'un espace 44, de sorte que les deux parties 43a, 43b de la couche de matériau électriquement conducteur 43 n'ont aucun point de contact l'une avec l'autre et ne sont pas connectées électriquement. Sur l'exemple de la Figure 4c, la partie 43b de la couche 43 de matériau électriquement conducteur recouvre une partie de la surface non structurée de l'ensemble « substrat 40 / couche diélectrique 41 » (i.e. la partie de la surface de l'ensemble « substrat 40 / couche diélectrique 41 » qui n'est pas au niveau de l'ouverture 42) ainsi que les parois et le fond de l'ouverture 42. Comme décrit ci-après, la partie 43a joue le rôle de « source » du transistor ionique du composant de stockage, et la partie 43b joue à la fois le rôle de « drain » du transistor ionique du composant de stockage et d'électrode inférieure de la capacité ionique du composant de stockage. Il est noté que les électrodes de source et de drain peuvent être interchangées (en particulier, l'électrode 43a peut représenter le drain et l'électrode 43a peut représenter la source).

La couche 43 de matériau électriquement conducteur peut être typiquement réalisée par dépôt sur toute la surface de l'ensemble « substrat 40 / couche diélectrique 41 » structuré de la Figure 4b (y compris les parois et le fond de l'ouverture 42), puis par structuration afin de réaliser l'espace 44 et de donner la forme et les dimensions souhaitées aux différentes parties de la couche 43. Par exemple, la couche 43 peut être déposée par pulvérisation cathodique sous vide, et la structuration peut être assurée par photolithographie suivie d'une gravure sèche.

Dans certains modes de réalisation, le dépôt de la couche 43 de matériau électriquement conducteur peut avantageusement être un dépôt conforme sur la surface de l'ensemble « substrat 40 / couche diélectrique 41 » structuré, c'est-à-dire que son épaisseur constante sur toute la surface. Cela simplifie le procédé de fabrication de l'élément de stockage électrochimique d'énergie, puisqu'une seule couche peut être déposée le long de la surface sans nécessité de faire varier l'épaisseur en ajoutant des couches additionnelles.

Dans certains modes de réalisation, la couche 43 peut être une couche métallique de titane ayant une épaisseur e (qui correspond à la dimension selon l'axe y sur la Figure 4c, i.e. selon la direction orthogonale à la surface du substrat 40) comprise entre 10 et 200 nm, par exemple égale à 100 nm.

En référence à nouveau à la Figure 5, lors d'une étape 530, une couche d'un matériau d'insertions d'ions appelée couche de canal est déposée au niveau de l'espace entre l'électrode de source et l'électrode de drain du transistor ionique, de sorte à être en contact à la fois avec l'électrode de source et l'électrode de drain du transistor ionique.

Cette étape 530 est illustrée sur la Figure 4d : une couche 45 d'un matériau d'insertion d'ions est formée et structurée de sorte à recouvrir la partie de la couche 41 localisée au niveau de l'espace 34, ainsi que des portions des parties 43a et 43b de la couche 43, lesdites portions incluant les extrémités des parties 43a et 43b situées au niveau de l'espace 44. Comme décrit ci-après, cette couche 45 constitue le canal du transistor ionique du composant de stockage, et est donc en contact avec la source 43a, le drain 43b et la partie de la couche 41 localisée au niveau de l'espace 44.

Le canal 45 est composé d'un matériau d'insertion d'ions permettant d'intercaler et de dé-intercaler des ions sous l'application d'un champ électrique et, ainsi, de changer la conductivité électrique du canal 45 en fonction du taux d'intercalation. Par exemple, le matériau composant le canal 45 peut être un oxyde de métal de transition, et plus particulièrement un métal à base de nanoparticules de dioxyde de titane (TiO₂) ayant une taille d'environ 10 nm, pouvant intercaler les ions lithium (Li+). Le canal 45 peut, par exemple, avoir une épaisseur de l'ordre de quelques nanomètres à quelques dizaines de nanomètres.

De référence à nouveau à la Figure 5, lors d'une étape 540, une couche d'un matériau à la fois conducteur ionique et diélectrique peut être déposée sur la surface de l'élément obtenu à l'issue de l'étape 530.

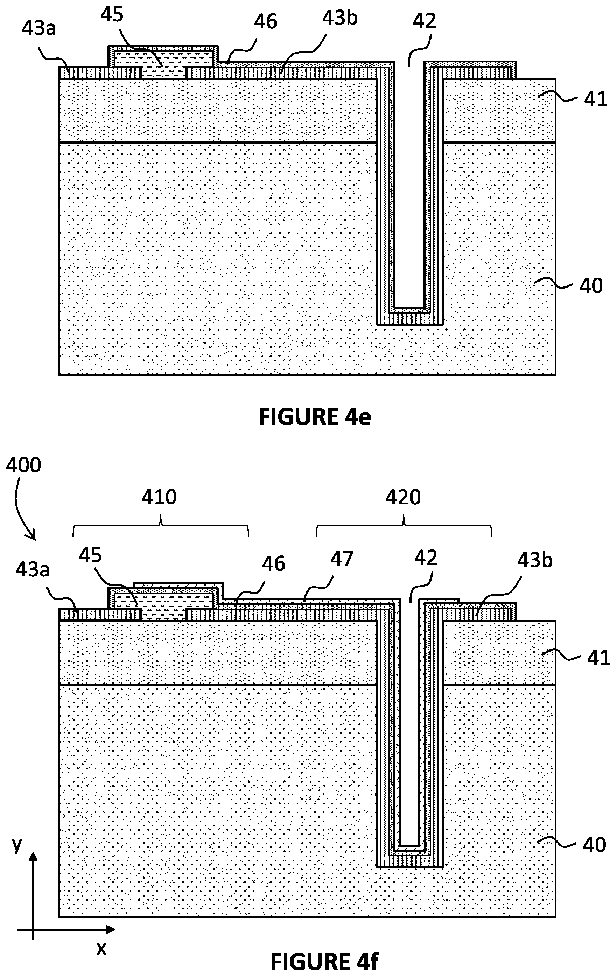

Cette étape 540 est illustrée sur la Figure 4e : une couche 46 de conducteur ionique et diélectrique est déposée sur la surface et structurée. La couche 46 est conductrice pour les mêmes ions que le matériau d'insertions d'ions composant le canal 45. Par exemple, si le canal 45 est dans un matériau permettant l'intercalation d'ions Li+, le matériau de la couche 46 est conducteur pour les ions Li+.

La couche 46 de conducteur ionique et diélectrique est en contact avec la source 43a et le drain 43b, permettant aux ions de circuler entre ces deux électrodes 43a, 43b via le canal 45. La couche de conducteur ionique 46 recouvre une portion de la partie 43b de la couche 43 de matériau électriquement conducteur, ladite portion de la partie 43b de la couche 43 de matériau électriquement conducteur incluant la portion de la partie 43b de la couche 43 de matériau électriquement conducteur au niveau de l'ouverture 42. La couche 46 est « continue » (dans le sens où elle ne présente pas de « trou » ou d'interruption) depuis un point de contact avec la source 43a et la partie de la couche 43b située de l'autre côté de l'ouverture 42 par rapport au canal 45. La couche 46 conductrice ionique forme donc à la fois la couche conductrice ionique du transistor ionique et la couche conductrice ionique de la capacité ionique. La couche 46 permet donc aux ions de circuler à la fois entre les électrodes du transistor ionique et entre les électrodes de la capacité ionique.

La couche 46 est composée d'un matériau conducteur ionique et diélectrique, qui permet aux ions de circuler à la fois entre la source 43a et le drain 43b du transistor ionique de l'élément de stockage, et entre les deux électrodes 43b et 47b de la capacité ionique de l'élément de stockage, tout en assurant une isolation électrique entre les différentes paires électrodes. Par exemple, ce matériau peut être un oxynitrure de phosphore de lithium (LiPON). La couche 46 peut avoir une épaisseur de quelques dizaines à quelques centaines de nm, par exemple 100 nm. Dans certains modes de réalisation, cette couche 46 est déposée par pulvérisation cathodique magnétron. La structuration peut être effectuée par photolithographie par exemple.

Dans certains modes de réalisation, le dépôt de la couche 46 de matériau conducteur ionique et diélectrique peut avantageusement être un dépôt conforme sur la surface de l'élément de la Figure 4d.

Enfin, lors d'une étape 550 de la Figure 5, une couche d'un matériau électriquement conducteur peut être déposée sur la surface de l'élément obtenu à l'issue de l'étape 540, puis structurée.

Cette étape 550 est illustrée sur la Figure 4f, dans laquelle une couche 47 d'un matériau électriquement conducteur est déposée sur au moins une partie de la couche 46. Après structuration éventuelle, cette couche est avantageusement « continue » depuis une zone de la couche conductrice ionique 46 située au niveau du canal 45 jusqu'à une zone de la couche conductrice ionique 46 située de l'autre côté de l'ouverture 42 par rapport au canal 45. Cette couche 46 forme à la fois la grille du transistor ionique et l'électrode supérieure de la capacité ionique. Dans certains modes de réalisation, le dépôt de la couche 47 de matériau électriquement conducteur peut avantageusement être un dépôt conforme sur la surface de l'élément de la Figure 4e.

Par exemple, la couche 47 peut être une couche métallique de titane ayant une épaisseur de 100 nm, déposée par pulvérisation cathodique sous vide. La structuration de la couche 47 peut être par exemple réalisée par photolithographie et gravure sèche.

Les exemples de mode de réalisation ci-dessus se concentrent sur un composant mémoire à fonctionnement d'ions lithium Li+, mais il est tout à fait possible d'utiliser d'autres ions porteurs de charge, tels que des ions Na+, H+, K+, Cu+, etc.

L'élément de stockage électrochimique d'énergie 400 de la Figure 4f est représenté en coupe sur le plan (x, y). Dans un ou plusieurs modes de réalisation, la largeur de canal peut être inférieure à 200 nm, préférentiellement inférieure à 20 nm. La largeur de canal correspond à la dimension selon l'axe z (z étant le troisième axe d'un repère orthonormal (x, y, z)) du canal 45 du transistor ionique 420. La largeur de la capacité ionique 420 (i.e. la dimension de la capacité ionique 420 selon l'axe z) peut être inférieure à 2 µm, préférentiellement inférieure à 1 µm. La profondeur de capacité ionique 420 (i.e. sa dimension selon l'axe y) peut être supérieure à 2 µm, préférentiellement supérieure à 5 µm.

L'élément électrochimique de stockage 400 obtenu à l'issue des différentes étapes représentées aux Figure 4a à 4f comprend un transistor ionique 410 (de structure similaire au transistor ionique 1 représenté à la Figure 1a) et une capacité ionique 410 (de structure similaire à la capacité ionique 2 représentée à la Figure 2a), dans lequel :
- l'électrode de grille du transistor ionique 410 et l'électrode supérieure de la capacité ionique 420 sont connectées (et ici, formées dans une même couche 47 de matériau électriquement conducteur), et
- l'électrode de drain du transistor ionique 410 et l'électrode inférieure de la capacité ionique 420 sont connectées (et ici, formées dans une même couche 43b de matériau électriquement conducteur).

Comme mentionné précédemment, le drain 43b et la source 43b du transistor ionique 410 sont interchangeables. Aussi, sur le schéma de la Figure 4f, l'électrode 43a pourrait correspondre au drain, et l'électrode 43b pourrait correspondre à la source du transistor.

Le transistor ionique 410 et la capacité ionique 420 sont réalisés de façon monolithique sur le même niveau du substrat 40. Comme il apparaît ci-dessus, un tel élément peut être fabriqué en mutualisant certaines étapes de fabrication du transistor et de la capacité ionique (dépôt d'une même couche pour les deux composants et structuration).

Bien entendu, l'élément 400 de la Figure 4f n'est un exemple d'un élément électrochimique de stockage tel que présenté en référence à la Figure 3a. L'invention ne se limite pas à cet exemple. Par exemple, le transistor ionique et la capacité ionique peuvent être deux composants fabriqués séparément sur deux substrats distincts et connectés selon le schéma de la Figure 3a, avec ou sans la présence d'un élément intermédiaire de connexion (par exemple un multiplexeur ou un interrupteur). Selon certains modes de réalisation, d'autres composants peuvent être intercalés entre le transistor ionique et la capacité ionique. Le transistor ionique et/ou la capacité ionique peuvent également comprendre des couches additionnelles. Par exemple, une couche intercalaire dans un matériau d'insertion d'ions dissociée de celle du transistor ionique peut être implémentée dans l'architecture de la capacité ionique, de sorte à avoir une capacité hybride. Par exemple, cette couche intercalaire peut être insérée au niveau de la capacité ionique, entre la couche 43b et la couche 46 de la Figure 4f, i.e. entre l'électrode inférieure et la couche conductrice ionique de la capacité ionique. Une telle implémentation permet d'augmenter davantage la valeur de la densité de capacitance (en pratique, celle-ci peut être doublée en comparaison avec une isoarchitecture sans couche intercalaire), comme décrit par exemple dans l'article de V. Sallaz et al. « Hybrid All-Solid-State Thin-Film Micro-supercapacitor Based on a Pseudocapacitive Amorphous TiO2 Electrode », ACS Appl. Energy Mater. 2023, 6, 1, 201-210. Une telle couche intercalaire peut être obtenue à partir du procédé de fabrication de la Figure 5 : à l'étape 530, la couche de matériau d'insertion d'ions peut être déposée sur toute la surface, et structurée en deux parties disjointes : l'une correspondant à la couche de canal du transistor ionique, l'autre correspondant à la couche intercalaire de la capacité ionique.

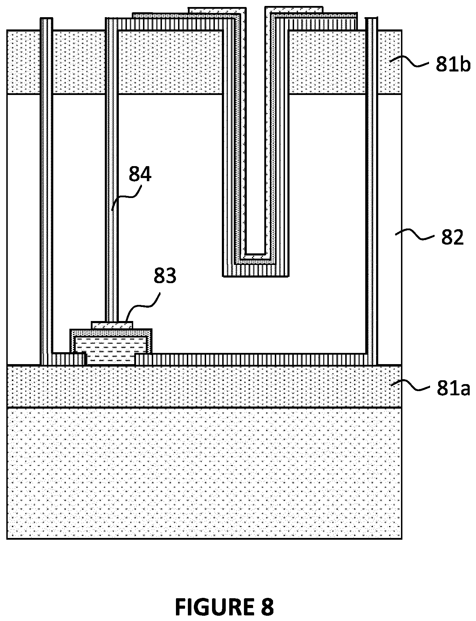

En outre, même si le transistor ionique 410 et la capacité ionique 420 de l'élément 400 de la Figure 4f sont sur un même niveau de substrat, il est possible de superposer le transistor ionique et la capacité ionique sur deux niveaux différents verticalement par rapport au plan du substrat pour augmenter la densité d'intégration de l'élément électrochimique de stockage. La Figure 8 représente un tel exemple de dispositif. Sur l'exemple de la Figure 8, le transistor ionique est réalisé sur une couche inférieure de substrat 81a et la capacité ionique est réalisée sur une couche supérieure de substrat 81b, les couches 81a et 81b étant séparées par une couche 82 de matériau diélectrique. La grille 83 du transistor ionique est relié à l'électrode inférieure 84 de la capacité ionique.

## Revendications

1. Dispositif (400) électrochimique de stockage de charges comprenant un transistor ionique (410) et une capacité ionique (420),
le transistor ionique comprenant :
- une couche (45) formant un réservoir d'ions, appelée couche réservoir ;
- une électrode de source (43a) en contact avec une partie de la couche réservoir (45) ;
- une électrode de drain (43b) en contact avec une autre partie de la couche réservoir (45), l'électrode de drain (43b) et l'électrode de source (43a) étant physiquement séparées l'une de l'autre, l'électrode de source (43a) et l'électrode de drain (43b) étant chacune dans un matériau électriquement conducteur ; et
- une électrode de grille (47) dans un matériau électriquement conducteur, l'électrode de grille étant séparée de la couche réservoir par une couche conductrice ionique (46) dans un matériau conducteur ionique et diélectrique ;
la capacité ionique (420) comprenant deux électrodes (43b, 47), chacune des deux électrodes (43b, 47) étant dans un matériau électriquement conducteur, la capacité ionique (420) comprenant une couche conductrice ionique (46) séparant les deux électrodes (43b, 47) de la capacité ionique (420), la couche conductrice ionique de la capacité ionique (420) étant dans un matériau conducteur ionique et diélectrique ;
**caractérisé en ce que** le dispositif comprend en outre un élément de connexion apte à connecter l'électrode de grille du transistor ionique à une première électrode (47) parmi les deux électrodes de la capacité ionique, et
**en ce que** la couche conductrice ionique (46) est en contact avec l'électrode de source (43a) et avec l'électrode de drain (43b).

2. Dispositif (400) selon la revendication 1, dans lequel l'une des électrodes (43b) parmi l'électrode de source et l'électrode de drain du transistor ionique est connectée à une deuxième électrode (43b) parmi les deux électrodes de la capacité ionique, la deuxième électrode (43b) étant distincte de la première électrode (47).

3. Dispositif (400) selon l'une des revendications 1 et 2, dans lequel l'élément de connexion est un élément apte à connecter, directement ou indirectement, l'électrode de grille du transistor ionique à la première électrode de la capacité ionique.

4. Dispositif (400) selon l'une des revendications précédentes, dans lequel l'élément de connexion est un élément parmi une couche en un matériau électriquement conducteur, un via conducteur, un interrupteur ou un multiplexeur.

5. Dispositif (400) selon l'une des revendications précédentes, dans lequel la couche conductrice ionique (46) du transistor ionique et la couche conductrice ionique (46) de la capacité ionique sont communes.

6. Dispositif (400) selon l'une des revendications précédentes, dans lequel l'électrode de grille (47) du transistor ionique et ladite première électrode (47) de la capacité ionique sont communes.

7. Dispositif (400) selon l'une des revendications précédentes en combinaison avec la revendication 2, dans lequel l'électrode de source (43a) du transistor ionique, l'électrode de drain (43b) du transistor ionique et la deuxième électrode (43b) de la capacité ionique sont dans un même matériau électriquement conducteur et ont une même épaisseur.

8. Dispositif (400) selon la revendication 7, dans lequel l'électrode (43b), parmi l'électrode de drain et l'électrode de source, du transistor ionique connectée à la deuxième électrode de la capacité ionique est appelée électrode de connexion du transistor ionique, dans lequel l'électrode de connexion du transistor ionique et la deuxième électrode (43b) de la capacité ionique sont communes.

9. Dispositif (400) selon l'une des revendications précédentes, dans lequel le transistor ionique (410) et la capacité ionique (420) sont formés sur un même substrat (40, 41), de manière monolithique.

10. Dispositif (400) selon la revendication 9, dans lequel le transistor ionique (410) et la capacité ionique (420) sont situés sur un même niveau du substrat (40, 41).

11. Dispositif (400) selon la revendication 9 ou 10, dans lequel le substrat (40, 41) comprend un évidement (42), dans lequel au moins une partie de la capacité ionique (420) est logée dans l'évidement.

12. Dispositif (400) selon l'une des revendications précédentes, dans lequel la capacité ionique (420) comprend en outre une couche intercalaire dans un matériau réservoir d'ions, la couche intercalaire séparant la couche conductrice ionique (46) de la capacité ionique et l'électrode (43b), parmi les deux électrodes de la capacité ionique, autre que la première électrode.

13. Circuit de traitement neuromorphique de type « intégrateur de paires différentielles » comprenant un dispositif électrochimique de stockage de charges selon l'une des revendications 1 à 12.

14. Procédé de fabrication d'un dispositif électrochimique de stockage de charges selon l'une des revendications 1 à 12, le procédé comprenant successivement :
- dépôt (520), sur un substrat, d'une première couche de matériau électriquement conducteur, et structuration de ladite première couche de sorte à obtenir une première partie de première couche et une deuxième partie de première couche n'ayant aucun point de contact, la première partie de première couche correspondant à une électrode parmi une électrode de source et une électrode de grille du transistor ionique, la deuxième partie de première couche correspondant à l'autre électrode parmi l'électrode de source et l'électrode de drain du transistor ionique et à une électrode de la capacité ionique ;
- dépôt (530) de la couche réservoir, la couche réservoir étant en contact avec la première partie de première couche et avec la deuxième partie de première couche ;
- dépôt (540) d'une couche conductrice ionique dans un matériau conducteur ionique et diélectrique, la couche conductrice ionique recouvrant au moins partiellement la première partie de première couche, toute la couche réservoir et au moins partiellement la deuxième partie de première couche ; et
- dépôt (550) d'une deuxième couche de matériau électriquement conducteur recouvrant au moins partiellement la couche conductrice ionique, la deuxième couche de matériau électriquement conducteur n'ayant aucun point de contact physique avec la première couche de matériau électriquement conducteur, la deuxième couche de matériau électriquement conducteur formant une électrode de grille du transistor ionique et une autre électrode de la capacité ionique.

15. Procédé de fabrication selon la revendication précédente, dans lequel le dépôt d'au moins une couche parmi la première couche de matériau électriquement conducteur, la couche conductrice ionique et la deuxième couche de matériau électriquement conducteur est un dépôt conforme.

## Patentansprüche

1. Elektrochemische Ladungsspeichervorrichtung (400) mit einem Ionen-Transistor (410) und einem Ionen-Kondensator (420),
wobei der Ionen-Transistor umfasst:
- eine Schicht (45), die ein lonenreservoir bildet, die als Reservoirschicht bezeichnet wird;
- eine Source-Elektrode (43a), die mit einem Teil der Reservoirschicht (45) in Kontakt steht;
- eine Drain-Elektrode (43b), die mit einem anderen Teil der Reservoirschicht (45) in Kontakt steht, wobei die Drain-Elektrode (43b) und die Source-Elektrode (43a) physikalisch voneinander getrennt sind und die Source-Elektrode (43a) und die Drain-Elektrode (43b) jeweils aus einem elektrisch leitenden Material bestehen; und
- eine Gate-Elektrode (47) aus einem elektrisch leitfähigen Material, wobei die Gate-Elektrode von der Reservoirschicht durch eine ionenleitende Schicht (46) aus einem ionenleitenden und dielektrischen Material getrennt ist;
wobei der Ionen-Kondensator (420) zwei Elektroden (43b, 47) umfasst, die beide (43b, 47) aus einem elektrisch leitfähigen Material bestehen, wobei der Ionen-Kondensator (420) eine ionenleitende Schicht (46) umfasst, die die beiden Elektroden (43b, 47) des Ionen-Kondensators (420) voneinander trennt, wobei die ionenleitende Schicht des Ionen-Kondensators (420) aus einem ionenleitenden und dielektrischen Material besteht;
**dadurch gekennzeichnet, dass** die Vorrichtung ferner ein Verbindungselement umfasst, das dazu ausgelegt ist, die Gate-Elektrode des Ionen-Transistors mit einer ersten Elektrode (47) der beiden Elektroden des Ionen-Kondensators zu verbinden, und
dass die ionenleitende Schicht (46) mit der Source-Elektrode (43a) und mit der Drain-Elektrode (43b) in Kontakt steht.

2. Vorrichtung (400) nach Anspruch 1, bei der eine der Elektroden (43b) aus der Source-Elektrode und der Drain-Elektrode des Ionen-Transistors mit einer zweiten Elektrode (43b) aus den beiden Elektroden (43a, 43b) des Ionen-Kondensators verbunden ist, wobei sich die zweite Elektrode (43b) von der ersten Elektrode (47) unterscheidet.

3. Vorrichtung (400) nach einem der Ansprüche 1 und 2, bei der das Verbindungselement ein Element ist, das geeignet ist, die Gate-Elektrode des Ionen-Transistors direkt oder indirekt mit der ersten Elektrode des Ionen-Kondensators zu verbinden.

4. Vorrichtung (400) nach einem der vorstehenden Ansprüche, bei der das Verbindungselement ein Element aus der Gruppe bestehend aus einer Schicht aus einem elektrisch leitfähigen Material, einer leitfähigen Durchkontaktierung, einem Schalter oder einem Multiplexer ist.

5. Vorrichtung (400) nach einem der vorstehenden Ansprüche, bei der die ionenleitende Schicht (46) des Ionen-Transistors und die ionenleitende Schicht (46) des Ionen-Kondensators identisch sind.

6. Vorrichtung (400) nach einem der vorstehenden Ansprüche, bei der die Gate-Elektrode (47) des Ionen-Transistors und die erste Elektrode (47) des Ionen-Kondensators identisch sind.

7. Vorrichtung (400) nach einem der vorstehenden Ansprüche in Kombination mit Anspruch 2, bei der die Source-Elektrode (43a) des Ionen-Transistors, die Drain-Elektrode (43b) des Ionen-Transistors und die zweite Elektrode (43b) des Ionen-Kondensators aus demselben elektrisch leitenden Material bestehen und dieselbe Dicke aufweisen.

8. Vorrichtung (400) nach Anspruch 7, bei der die Elektrode (43b), aus Drain-Elektrode und Source-Elektrode des Ionen-Transistors, die mit der zweiten Elektrode des Ionen-Kondensators verbunden ist, als Verbindungselektrode des Ionen-Transistors bezeichnet wird, wobei die Verbindungselektrode des Ionen-Transistors und die zweite Elektrode (43b) des Ionen-Kondensators identisch sind.

9. Vorrichtung (400) nach einem der vorstehenden Ansprüche, bei der der Ionen-Transistor (410) und der Ionen-Kondensator (420) monolithisch auf demselben Substrat (40, 41) ausgebildet sind.

10. Vorrichtung (400) nach Anspruch 9, bei der der Ionen-Transistor (410) und der Ionen-Kondensator (420) auf derselben Ebene des Substrats (40, 41) angeordnet sind.

11. Vorrichtung (400) nach Anspruch 9 oder 10, bei der das Substrat (40, 41) eine Aussparung (42) aufweist, bei der zumindest ein Teil des Ionen-Kondensators (420) in der Aussparung untergebracht ist.

12. Vorrichtung (400) nach einem der vorstehenden Ansprüche, bei der der Ionen-Kondensator (420) ferner eine Zwischenschicht aus einem lonenreservoirmaterial umfasst, wobei die Zwischenschicht die ionenleitende Schicht (46) des Ionen-Kondensators von der Elektrode (43b) trennt, die eine der beiden Elektroden des Ionen-Kondensators ist, jedoch nicht die erste Elektrode.

13. Neuromorphe Verarbeitungsschaltung vom Typ "Differentialpaarintegrator", die eine elektrochemische Ladungsspeichervorrichtung nach einem der Ansprüche 1 bis 12 umfasst.

14. Verfahren zur Herstellung einer elektrochemischen Ladungsspeichervorrichtung nach einem der Ansprüche 1 bis 12, wobei das Verfahren nacheinander umfasst:
- Aufbringen (520) einer ersten Schicht aus elektrisch leitendem Material auf ein Substrat und Strukturieren dieser ersten Schicht, um einen ersten Teil der ersten Schicht und einen zweiten Teil der ersten Schicht zu erhalten, die keinen Kontaktpunkt aufweisen, wobei der erste Teil der ersten Schicht einer Elektrode entspricht, die entweder eine Source-Elektrode oder eine Gate-Elektrode des Ionen-Transistors ist, und der zweite Teil der ersten Schicht der anderen Elektrode entspricht, die entweder die Source-Elektrode oder die Drain-Elektrode des Ionen-Transistors ist, sowie einer Elektrode des Ionen-Kondensators;
- Aufbringen (530) der Reservoirschicht, wobei die Reservoirschicht mit dem ersten Teil der ersten Schicht und mit dem zweiten Teil der ersten Schicht in Kontakt steht;
- Aufbringen (540) einer ionenleitenden Schicht aus einem ionenleitenden und dielektrischen Material, wobei die ionenleitende Schicht zumindest teilweise den ersten Teil der ersten Schicht, die gesamte Reservoirschicht und zumindest teilweise den zweiten Teil der ersten Schicht bedeckt; und
- Aufbringen (550) einer zweiten Schicht aus elektrisch leitendem Material, die die ionenleitende Schicht zumindest teilweise bedeckt, wobei die zweite Schicht aus elektrisch leitendem Material keinen physikalischen Kontaktpunkt mit der ersten Schicht aus elektrisch leitendem Material aufweist und die zweite Schicht aus elektrisch leitendem Material eine Gate-Elektrode des Ionen-Transistors und eine weitere Elektrode des Ionen-Kondensators bildet.

15. Herstellungsverfahren nach dem vorstehenden Anspruch, bei dem das Aufbringen mindestens einer Schicht aus der ersten Schicht aus elektrisch leitendem Material, der ionenleitenden Schicht und der zweiten Schicht aus elektrisch leitendem Material ein konformes Aufbringen ist.

## Claims

1. An electrochemical charge storage device (400) comprising an ionic transistor (410) and an ionic capacitor (420),
the ionic transistor comprising:
- a layer (45) forming an ion reservoir, called reservoir layer;
- a source electrode (43a) in contact with a part of the reservoir layer (45);
- a drain electrode (43b) in contact with another part of the reservoir layer (45), the drain electrode (43b) and the source electrode (43a) being physically separated from each other, the source electrode (43a) and the drain electrode (43b) each being made of an electrically conductive material; and
- a gate electrode (47) of an electrically conductive material, the gate electrode being separated from the reservoir layer by an ionic conductive layer (46) of an ionic conductive and dielectric material;
the ionic capacitor (420) comprising two electrodes (43b, 47), each of the two electrodes (43b, 47) being of an electrically conductive material, the ionic capacitor (420) comprising an ionic conductive layer (46) separating the two electrodes (43b, 47) of the ionic capacitor (420), the ionic conductive layer of the ionic capacitor (420) being of an ionic conductive and dielectric material;
**characterized in that** the device further comprises a connection element able to connect the gate electrode of the ionic transistor to a first electrode (47) of the two electrodes of the ionic capacitor,
and **in that** the ionic conductive layer (46) is in contact with the source electrode (43a) and with the drain electrode (43b).

2. The device (400) according to claim 1, wherein one (43b) of the source electrode and the drain electrode of the ionic transistor is connected to a second electrode (43b) of the two electrodes of the ionic capacitor, the second electrode (43b) being distinct from the first electrode (47).

3. The device (400) according to one of claims 1 and 2, wherein the connection element is an element able to connect, directly or indirectly, the gate electrode of the ionic transistor to the first electrode of the ionic capacitor.

4. The device (400) according to one of the preceding claims, wherein the connection element is one of a layer of electrically conductive material, a conductive via, a switch or a multiplexer.

5. The device (400) according to any of the preceding claims, wherein the ion conducting layer (46) of the ionic transistor and the ion conducting layer (46) of the ionic capacitor are common.

6. The device (400) according to one of the preceding claims, wherein the gate electrode (47) of the ionic transistor and said first electrode (47) of the ionic capacitor are common.

7. The device (400) according to one of the preceding claims in combination with claim 2, wherein the source electrode (43a) of the ionic transistor, the drain electrode (43b) of the ionic transistor and the second electrode (43b) of the ionic capacitor are of a same electrically conductive material and have a same thickness.

8. The device (400) according to claim 7, wherein the electrode (43b), among the drain electrode and the source electrode, of the ionic transistor connected to the second electrode of the ionic capacitor is called connection electrode of the ionic transistor, wherein the connection electrode of the ionic transistor and the second electrode (43b) of the ionic capacitor are common.

9. The device (400) according to one of the preceding claims, wherein the ionic transistor (410) and the ionic capacitor (420) are monolithically formed on a same substrate (40, 41).

10. The device (400) according to claim 9, wherein the ionic transistor (410) and the ionic capacitor (420) are located on a same level of the substrate (40, 41).

11. The device (400) according to claim 9 or 10, wherein the substrate (40, 41) comprises a recess (42), wherein at least a part of the ionic capacitor (420) is housed in the recess.

12. The device (400) according to any of the preceding claims, wherein the ionic capacitor (420) further comprises an interlayer of an ion reservoir material, the interlayer separating the ionic conductive layer (46) of the ionic capacitor and the electrode (43b), among the two electrodes of the ionic capacitor, other than the first electrode.

13. A neuromorphic processing circuit of the "differential pair integrator" type comprising an electrochemical charge storage device according to one of claims 1 to 12.

14. A method for manufacturing an electrochemical charge storage device according to one of claims 1 to 12, the method successively comprising:
- depositing (520), onto a substrate, a first layer of electrically conductive material, and structuring said first layer so as to obtain a first part of first layer and a second part of first layer having no point of contact, the first part of first layer corresponding to one electrode among a source electrode and a gate electrode of the ionic transistor, the second part of first layer corresponding to the other electrode among the source electrode and the drain electrode of the ionic transistor and to an electrode of the ionic capacitor;
- depositing (530) the reservoir layer, the reservoir layer being in contact with the first part of first layer and with the second part of first layer;
- depositing (540) an ionic conductive layer of an ionic conductive and dielectric material, the ionic conductive layer at least partially covering the first part of first layer, the entire reservoir layer and at least partially the second part of first layer; and
- depositing (550) a second layer of electrically conductive material at least partially covering the ionic conductive layer, the second layer of electrically conductive material having no point of physical contact with the first layer of electrically conductive material, the second layer of electrically conductive material forming a gate electrode of the ionic transistor and another electrode of the ionic capacitor.

15. The method for manufacturing according to the preceding claim, wherein the deposition of at least one of the first layer of electrically conductive material, the ionic conductive layer and the second layer of electrically conductive material is a conformal deposition.
